Europäisches Patentamt

European Patent Office

Office européen des brevets

(11) Publication number: **0 209 829 B1**

## EUROPEAN PATENT SPECIFICATION

(45) Date of publication of patent specification: **03.06.92**  (51) Int. Cl.⁵: **H03K 3/356**

(21) Application number: **86109657.6**

(22) Date of filing: **14.07.86**

(54) Sequential-logic basic element and network in CMOS technologyy.

(30) Priority: **17.07.85 IT 6765685**

(43) Date of publication of application:
**28.01.87 Bulletin 87/05**

(45) Publication of the grant of the patent:
**03.06.92 Bulletin 92/23**

(84) Designated Contracting States:
**DE FR GB NL SE**

(56) References cited:
**WO-A-84/03806**
**US-A- 4 554 467**

**PATENT ABSTRACTS OF JAPAN, vol. 8, no.
107 (E-245)[1544], 19th May 1984; & JP-A-59
22 435**

**PATENT ABSTRACTS OF JAPAN, vol. 10, no.
175 (E-413)[2231], 20th June 1986; & JP-A-61
25 321**

**Lexicon der Mikroelektronic, IWT Verlag
GmbH München, 1987, 74, 474, 531**

**N.E. Weste, K. Eshreghian, "Principle of
CMOS VLSI Design- A Systems Perspective", Addison-Wesley Publishing Company,**

**1985 pages 7,8,38,39,56 and 57**

(73) Proprietor: **CSELT Centro Studi e Laboratori
Telecomunicazioni S.p.A.
Via Guglielmo Reiss Romoli, 274
I-10148 Turin(IT)**

(72) Inventor: **Fassino, Mario
Via Borgosesia, 46 bis
Torino(IT)**
Inventor: **Ghisio, Guido
C.so Vercelli, 19
Ivrea Torino(IT)**

(74) Representative: **Riederer Freiherr von Paar zu
Schönau, Anton et al
Van der Werth, Lederer & Riederer Freyung
615 Postfach 2664
W-8300 Landshut(DE)**

## Description

The present invention concerns sequential logic circuits and more particularly a sequential-logic basic-element in CMOS technology operating by a single clock signal, and a logic network using such basic elements. It starts out from a prior art according to JP-A-59-22435, the introductory part of claim 1 defining a combined view of Fig.s 2 and 5 of this document. Therein, for the feedback loop coupling the logic level voltage from the voltage source to the inverter input, a simple series transistor controlled by the clock signal is used, with the result of some commutation problems since the positive reaction is still active after the transition of the clock signal and, due to the "body effect", its interruption depends on the available current of the input signal.

Generally, CMOS technology has been long neglected owing to high production cost, which only lately have been reduced thanks to improvements both in fabricating process and in circuit schemes. In the field of implementation of VLSI integrated circuit, CMOS technology presents a number of advantages. When compared to implementations of equivalent complexity in NMOS technology, CMOS circuits are characterized by a very low dissipation limited only at switching instants, while under static conditions their dissipation is practically null. The intrinsically good noise-immunity makes CMOS circuits suited to be used on board of satellites and in telecommunication circuits in general, where reliability and noise immunity problems are more stringent. They are also suited to be used in analog circuits: this allows the development of circuit systems comprising both analog and digital elements on the same chip.

In MOS-technology circuits generally in use, the timing control of the sequential-logic elements is made by means of the so-called "transfer-gate" transistors, which interrupt or allow the signal flow on the line in a mode similar to the switching on/off of a switch. Such transistors are driven by two clock signals forming a two-phase timing. The two clock signals can simply have two opposite logic levels or provide also additional periods in which both present a non-active logic level, to assure greater stability in the signal logic levels. The latter are referred to as "non overlapping phases" which, notwithstanding, to be implemented, need rather complex circuit structures which occupy significant portions of integrated circuit area, and require great care to balance the load distributions on each of them so as not to alter phase relations of the produced signals. In any case a two-phase timing requires the presence of two conduction paths inside the integrated circuit, with consequent circuit complexity increase.

A sequential logic basic-element in CMOS technology using a single clock signal is known and described in the article: "Efficient custom digital IC design for control applications", Proceedings of the 4th International Conference on Custom and Semi-custom ICs; 6-8 November 1984, London. Said known structure uses two PMOS and two NMOS transfer-gate transistors as well as a conventional CMOS inverter, the latter consisting of two enhancement MOS transistors, the one P-channel, the other N-channel, arranged in series. Even though this structure is implemented in CMOS technology, its operation is of "quasi-NMOS" type, i. e. the circuit dissipates also under static conditions.

Also in this prior art, the critical condition occurs that when the input datum and the clock signal, respectively applied to the channel and to the gate of the first NMOS transfer-gate transistor, are at logic level "1", said transistor transfers inside the structure a logic level affected by a considerable voltage drop due to the transistor threshold voltage and to "body effect" such as to make the datum assume an uncertain logic condition.

Said problems are solved by the present invention, i. e. by a sequential logic basic-element in CMOS technology operating by a single clock signal, characterized in that for having an active phase at the low voltage level of the clock signal, said second positive feedback network comprises, besides the fourth transistor which is of the PMOS type, a fifth transistor of the NMOS type having the source connected to the output of the inverter, and the gate to the clock signal; and said third transistor has the drain connected to the input of the logic inverter, the gate of the third, the drain of the fourth and the drain of the fifth transistor being interconnected; and by a sequential logic network using such basic elements. Wherein the terms "source" and "drain" can taken physically as interchangeable, since the channel of the MOS transistors is symmetrical.

The invention will be now described with reference to an embodiment thereof and to a variant and combinations given by way of example and not in a limiting sense, and to the annexed drawings in which:

- Fig. 1 shows a first embodiment of the basic circuit provided by the invention, having the active phase at the low logic level of the clock signal;
- Fig. 2 shows a modification to be given to the circuit of Figure 1 to introduce the functions of asynchronous set and reset;
- Figures 3 and 4 show examples of sequential logic networks obtained by combining the circuit of Figure 1 with a flipflop having the active phase at the high logic level of the clock signal;

- Figures 5 and 6 show examples of sequential logic networks obtained by combining the circuit of Figure 2 with a comparable flipflop having the active phase at the high logic level of the clock signal.

Hereinafter the described sequential-logic basic elements will be referred to by the term "latch" which is usual in the art. Latches described here carry out the known basic operations of data transfer and/or storage, respectively controlled by the active and non-active level of the clock signal. Again, it has to be taken into account that hereinafter channel terminals "drain" and "source" of MOS transistors forming the latch will be univocally identified only for the sake of expounding clarity; actually said terminals can be physically taken as interchangeable, as the channel of said MOS transistors is symmetrical, and hence it is not necessary to functionally identify its terminations.

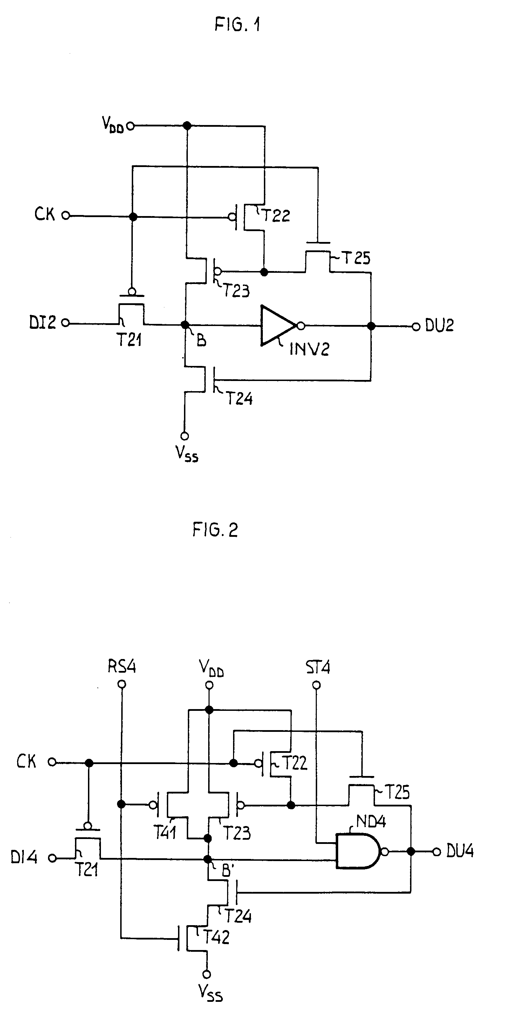

In Fig. 1, a P-type latch with active phase at the low voltage level of clock signal CK is shown. The latch is composed of PMOS transistors T21, T22, T23, of NMOS transistors T24, T25, all of the enhancement type, and of a logic inverter INV2, here indicated only by the circuit symbol in which, to simplify the drawing, the connections with supply voltages $V_{DD}$, $V_{SS}$ have not been shown.

T21 carries out the transfer-gate function for input data DI2 applied to the drain. Clock signal CK is applied to the gates of T21, T22, and T25.

The high-level supply voltage $V_{DD}$ is applied to the drains of T22, T23, while the low-level supply voltage $V_{SS}$ is applied to the source of T24.

The source of T21, T23, the drain of T24 and the input of the inverter INV2, are connected together in a node B.

The gate of T23 and the source of T22, T25 are connected together, while the output of INV2, which is also the data output DU2 of the latch, is fed back to the gate of T24 and to the drain of T25.

The operation of this circuit will be now described.

The logic level "0" of the clock signal CK cuts off transistor T25 and activates T21, T22; the latter cuts off T23 raising the gate voltage to $V_{DD}$. In this way the logic level of node B will be forced to the level of input signal DI2.

If DI2 is at "0", the voltage of node B will be that of DI2 reduced by the voltage drop dependent on the negative threshold voltage of T21 and on the "body" effect. Said voltage on node B is such as to cause at the output DU2 a voltage capable of activating T24, by introducing a positive feedback which is to strengthen and stabilize the logic levels both on node B (logic "0") and at the output DU2 (logic "1").

If, however, DI2 is at "1", the voltage of node B will be the same as that of DI2, such as to cause the output DU2, through INV2, to go to logic level "0" which cuts off T24. With CK at "0", the latch simply transfers the input data to the output with the logic level inverted. The logic level "1" of CK cuts off T21 and T22, and activates T25. If the signal of output DU2 is at "0", T23 which keeps node B at voltage $V_{DD}$ (logic "1") is activated through T25. Transistor T24 is cut off, decoupling the voltage of node B and supply voltage $V_{SS}$.

If, however, the signal of output DU2 is at "1", T23 is cut off, while T24 is activated which causes the voltage on node B to go to value $V_{SS}$, i. e. logic "0".

With CK at "1", the latch keeps the datum, previously introduced, stored.

The latch comprises two positive feedback networks: the first is transistor T24 which is to stabilize the logic level "0" when present on node B, i. e. the level which, without feedback, would be affected by the voltage drop caused by the threshold voltage of T21; the second consists of transistors T22, T23, T25 and is controlled by clock signal CK which when active (operation of the latch in data transfer) interrupts the feedback produced by said network, while when non-active (operation of the latch in data storage) enables it.

Fig. 2 shows circuit modifications to be made to the P-type latch to introduce the asynchronous set and reset functions.

In Fig. 2, T21,...,T25 denote the same transistors as those of Fig. 1 for which the description made in connection with Fig. 1 still holds as for both their interconnection and the operation relative to the basic functions of data transfer and storage.

ND4 denotes a NAND gate, which, besides carrying out the function of the inverter INV2 of Fig. 1, carries out also that of an asynchronous set. ND4 has an input connected to node B' (equivalent to node B of Fig. 1) and another input ST4 to the asynchronous set signal, active at logic level "0". The output of ND4 is data output DU4. The asynchronous reset function is obtained by the insertion of a transistor T41 of the enhancement PMOS type and of a transistor T42 of the enhancement NMOS type. The gates of T41 and T42 are connected to the input RS4 to which the asynchronous reset signal is carried, active at logic level "0"; T41 channel is connected in parallel with that of T23, while T42 channel is placed in series with that of T24 and supply voltage $V_{SS}$.

If RS4 is at "0", T42 is cut off, interrupting the conduction in the relevant network, while T41 is active, connecting $V_{DD}$ to node B': in this way the output DU4 will go to logic level "0" which is the one desired for the reset function. If RS4 is at "1", T41 is cut off while T42 conducts: hence their presence does not affect the behaviour of the rest of the circuit.

By duly interconnecting the circuits of Figures 1 or 2 with more or less complementary circuits, sequential circuits implementing fundamental logic functions can be obtained.

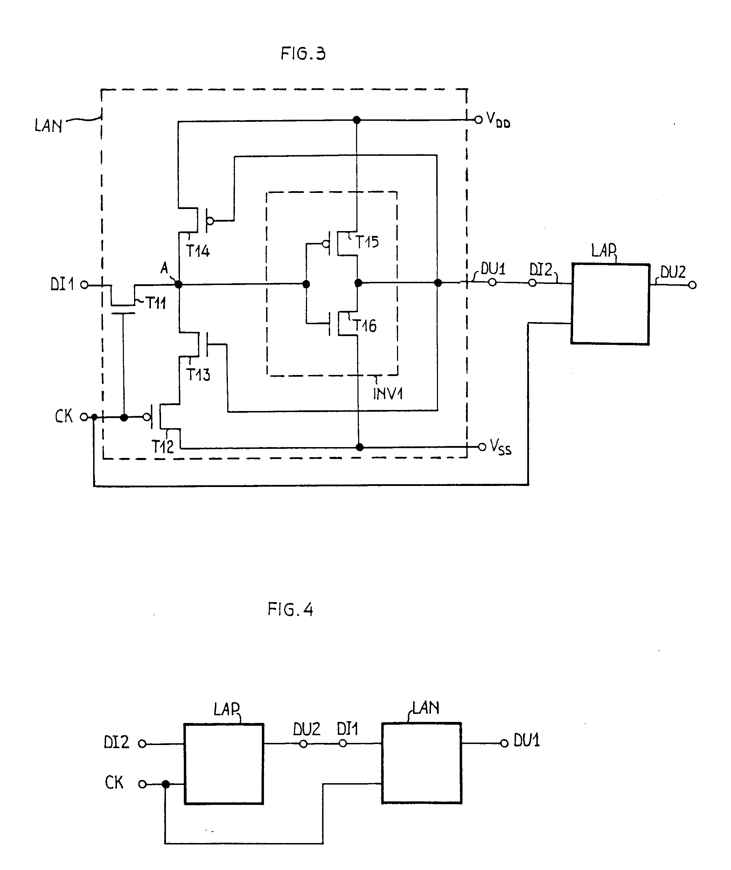

E. g. Fig. 3 shows a sequential circuit implementing D-type master-slave flip-flop function, which operates with the only clock signal CK. LAN denotes a flipflop operating as an N-type latch, while LAP denotes the P-type latch of Fig. 1. The N-type latch LAN, with active phase at the hight voltage level of clock signal CK, is composed of NMOS transistors T11, T13, T16, and of PMOS transistors T12, T14, T15, all of the enhancement type. T11 carries out the transfer-gate function for the data applied to input DI1 connected to the drain. The only clock signal CK is applied to the gate of T11 and T12. The high-level supply voltage $V_{DD}$ is applied to the drains of T14, T15, whilst low-level supply voltage $V_{SS}$ is applied to the sources of T12 and T16. The sources of T14 and T11, the drain of T13, and the gates of T15 and T16 are connected together in a node A. The source of T15 and the drain of T16 are connected together and form the date output DU1 of the latch LAN, which is also fed back to the gates of T13 and T14. The drain of T12 is connected to the source of T13. Transistors T15 and T16 form a logic inverter INV1 of known type, similar to inverter INV2 of Fig. 1, in which the data input is node A and the data output is the output DU1 of the latch.

The operation of the latch LAN is now described by the analysis of the logic levels at the internal nodes determined by the logic levels at the inputs.

The logic level "1" of clock signal CK cuts off transistor T12 and activates T11 which forces the voltage of node A at the logic level of input DI1. If DI1 is at logic "0", the output DU11 goes to "1", T14 is cut off and T13 can conduct, but the conduction is prevented by the state of T12. If, however, DI1 is at "1", the voltage of node A is that of the input DI1 reduced by the voltage drop dependent on the threshold voltage of T11 and on the "body" effect; such a voltage of node A is such as to cause at output DU1 a voltage capable of activating T14 conduction thus giving rise to a positive feedback which strengthens and stabilizes the logic levels both on node A (logic "1") and at the output of DU1 (logic "0"). Hence, with CK at "1", the latch simply transfers the input data, with the logic level inverted, to the output.

The logic level "0" of clock signal CK cuts off T11 and activates T12. If output DU1 is at "0", T14 is active and keeps node A at "1". T13 results cut off, decoupling signal CK and the signal of node A. If, however, DU1 is at "1", T14 is cut off, while T13 is active, allowing the correct logic condition (logic "0") to be maintained on node A which results connected to supply voltage $V_{SS}$.

With CK at "0", the latch keeps the datum, previously transferred into node A, stored.

The latch LAN comprises two positive feedback networks: the first consists of transistor T14 which is to stabilize logic level "1" when present on node A, i. e. the level which, without feedback, would be affected by the voltage drop caused by T11 threshold voltage; the second consists of transistors T13, T12, and is controlled by synchronism signal CK which, when active (operation of the latch in data transfer), interrupts the feedback produced by T13, while when non-active (operation of the latch in data storage) enables it.

The output DU1 of LAN is connected with the input DI2 of LAP; the clock inputs are connected together, and the output DU2 of LAP is the output of the sequential circuit.

The data input in LAN, which carries out the master function, takes place at the high logic level of CK, while the data output from LAP, which acts as a slave, takes place at the low logic level of CK.

By inverting the order of the two latches LAN, LAP of Fig. 3 another D-type master-slave flip-flop is obtained which operates with the single clock signal CK, shown in Fig. 4. In the case of Fig. 4, the data input is input DI2 of LAP, and the data output is the output DU1 of LAN: now LAP carries out the master function and the data input takes place when the logic level of CK is low, while LAN acts as a slave and the data output takes place when the logic level of CK is high.

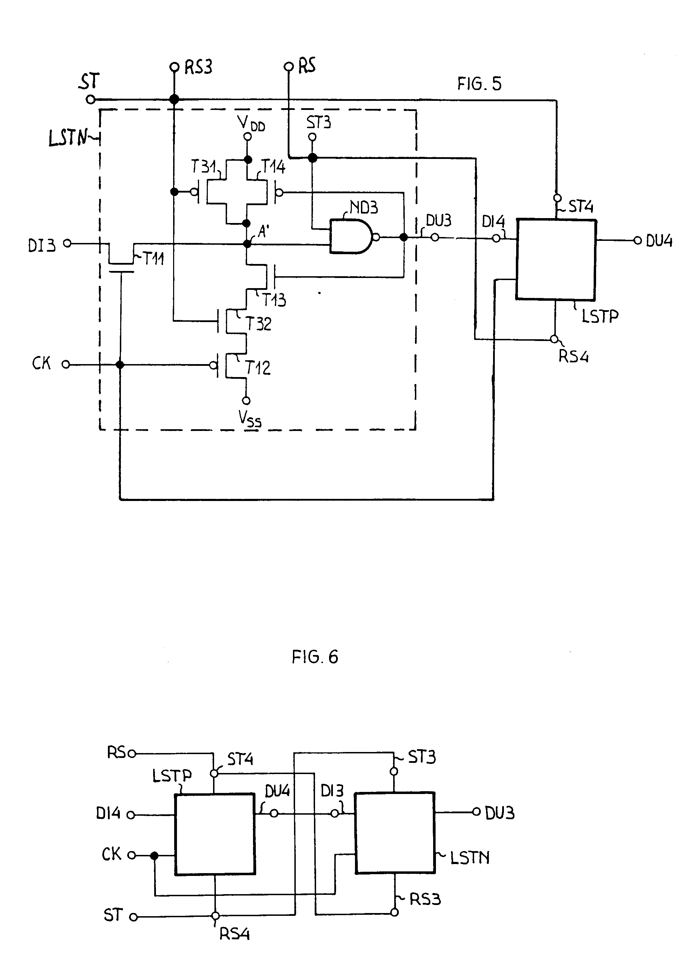

Fig. 5 shows an example of a D-type master-slave flip-flop with additional asynchronous set and reset functions, operating with the single clock signal CK.

LSTN denotes a flipflop operating as an N-type latch while LSTP denotes the P-type latch of Fig. 2.

LSTN is a latch circuit modified with reference to the N-type latch LAN of Fig. 3, to introduce asynchronous set and reset functions. T11,...,T14 denote the same transistors of Fig. 3 for which the description made in relation to Fig. 3 is still valid as to both their interconnection and the operation relevant to the basic functions of data transfer and storage. ND3 denotes a NAND gate which, besides carrying out the function of the inverter INV1 of Fig. 3, carries out also that of an asynchronous set. ND3 has an input connecte to node A' (equivalent to node A of Fig. 3) and the second input ST3 at the asynchronous set signal active at logic level "0". The output of ND3 is the data output DU3. If ST3 is at "0", the output of ND3 is forced at "1" (logic level desired for the asynchronous set function); if on the contrary ST3 is at "1", its presence does not affect the behaviour of the rest of the latch LSTN and hence the state of output DU3 is determined by that of node A'.

The asynchronous reset function is obtained by the insertion of PMOS enhancement transistor T31 adn NMOS enhancement transistor T32. The gates of T31 and T32 are connected to input RS3 to which the asynchronous reset is sent, active at logic level "0"; the channel of T31 is connected in parallel with that of T14, while the channel of T32 is in series with those of T13, T12.

If RS3 is at "0", T32 is cut off, interrupting the conduction of the relative network, while T31 is active, connecting $V_{DD}$ to node A': in this way the output DU3 will go to logic level "0" which is the one desired for the reset function. If RS3 is at "1", T31 is cut off while T32 conducts: hence their presence does not affect the behaviour of the rest of the circuit.

As to data input and output, what mentioned in connection with the example of Fig. 3 is also valid. The additional asynchronous set function is obtained by connecting together the inputs RS3 of LSTN and ST4 of LSTP whereto asynchronous set signal ST is applied. The additional asynchronous reset function is obtained by interconnecting the inputs ST3 of LSTN and RS4 of LSTP, whereto the asynchronous reset signal RS is applied.

By inverting the order of the two latches LSTN, LSTP of Fig. 5, another D-type master-slave flip-flop is obtained with the additional asynchronous set and reset functions, operating with the only clock signal CK, shown in Fig. 6: as to the data input and output, what mentioned in connection with the example of Fig. 4 is also valid. The supplementary asynchronous set function is obtained by interconnecting the inputs RS4 of LSTP and ST3 of LSTN whereto asynchronous set signal ST is applied; the asynchronous reset function is obtained by connecting together the inputs ST4 of LSTP and RS3 of LSTN whereto asynchronous reset signal RS is applied.

**Claims**

1.  Sequential-logic basic element in CMOS technology using transistors of the enhancement-type, which element carries out basic binary functions of data transfer and/or storage and which operates by a single clock signal (CK) whose active level controls the data transfer function and whose non-active level controls the data storage function, which element has current supply terminals ($V_{SS}$, $V_{DD}$) to be connected to supply voltages corresponding to the low and high binary levels, respectively, and basically comprises:
    - a logic inverter (INV2) whose output (DU2) is that of the basic element;
    - a first transistor (T21) of the PMOS type which transfers a datum applied to its input, which is also the input (DI2) of the basic element, to the input (B) of said logic inverter when said clock signal (CK), applied to its gate, has active level, otherwise it decouples the input of the basic element from that of the inverter;
    - a first positive feedback network between output and input of said logic inverter, containing a second transistor (T24) of NMOS type connected between the supply terminal for the voltage corresponding to the low binary level and the inverter input (B), the gate being connected to the inverter output (DU2), and switching through the respective supply voltage to the inverter input in case of a voltage close to the high logic level transferred to its gate from the inverter output;
    - a second positive feedback network (T23, T25) between output and input of said logic inverter, containing a third transistor (T23) of PMOS type coupled between the supply terminal for the voltage corresponding to the high binary level to which its source is connected and the inverter input (B), the current through the third transistor (T23) being controlled by at least one further transistor (T22, T25) by said clock signal (CK) which, when non-active, allows switching through the respective supply voltage to the inverter input in said third transistor under control of the voltage at the inverter output (DU2) transferred to its gate, the further, i. e. fourth transistor (T22) having its source connected to the supply terminal ($V_{DD}$) for the voltage corresponding to the high binary level, and the gate to said clock signal (CK),

    characterized in that for having an active phase at the low voltage level of the clock signal (CK),
    - said second positive feedback network comprises, besides the fourth transistor (T22) which is of the PMOS type, a fifth transistor (T25) of the NMOS type having the source connected to the output of the inverter (INV2), and the gate to the clock signal (CK); and
    - said third transistor (T23) has the drain connected to the input of the logic inverter (INV2); the gate of the third, the drain of the fourth and the drain of the fifth transistor being interconnected.

2.  Basic element as in claim 1, characterized in that, to carry out supplementary functions of asynchronous set and reset, it also comprises:

- said logic inverter (INV2) is realized with a NAND gate (ND4); an input and the output of said NAND gate replacing the input and output of the logic inverter; to a second input of said NAND gate a control signal (ST4) of said asynchronous set function being sent, said control signal being of the low-active type;
- a sixth transistor (T42) of the NMOS type, whose channel is placed in series with that of said second transistor (T24);
- a seventh transistor (T41) of the PMOS type, whose channel is arranged in parallel with that of said third transistor (T23); said sixth and seventh transistors receiving at the gate a control signal (RS4) of said asynchronous reset function, of the low-active type.

3. Sequential logic network in CMOS technology using the basic element of claim 1, characterized in that it implements a D-type master-slave flip-flop and comprises a first flipflop (LAN) having active phase at the high voltage level of the clock signal (CK) in master position, followed by a second one, i. e. said basic element (LAP) having active phase at the low voltage level of the clock signal in slave position; the input of the first flipflop being the network data input, the output of said basic circuit being the network data output; the output of the first flipflop being connected to the input of said basic element, said clock signal being sent to both the first flipflop and said basic element.

4. Sequential logic network in CMOS technology using the basic element of claim 1, characterized in that it implements a D-type master-slave flip-flop and comprises said basic elements (LAP) having active phase at the low voltage level of the clock signal (CK) in master position, followed by a second flipflop (LAN) having active phase at the high voltage level of the clock signal in slave position; the input of said basic element being the network data input, the output of the second flipflop being the network data output; the output of said basic element being connected to the input of the second flipflop, said clock signal being sent to both said basic elements and the second flipflop.

5. Sequential logic network in CMOS technology using the basic element of claim 2, characterized in that it implements a D-type master-slave flip-flop with supplementary asynchronous set and reset functions and comprises a third flipflop (LSTN) having active phase at the high voltage level of the clock signal (CK) in master position, followed by said basic element (LSTP) having active phase at the low voltage level of the clock signal in slave position; the input of the third flipflop being the network data input, the output of the said basic element being the network data output; the output of the third flipflop being connected to the input of said basic element, said clock signal being sent to both the third flipflop and said basic element; the gates of an eighth and a ninth transistor (T31, T32) being connected to the second input of said first NAND gate (ND4) to receive said control signal (ST) of the asynchronous set function; the second input of a second NAND gate (ND3) being connected to the gates of said sixth and seventh transistors (T41, T42) to receive said control signal (RS) of the asynchronous reset function.

6. Sequential logic network in CMOS technology using the basic element of claim 2, characterized in that it implements a D-type master-slave flip-flop with additional functions of asynchronous set and reset and comprises said basic element (LSTP) having active phase at the low voltage level of the clock signal (CK) in master position, followed by a fourth flipflop (LSTN) having active phase at the high voltage level of the clock signal in slave position; the input of said basic element being the network data input, the output of the fourth flipflop being the network data output, the output of said basic element being connected to the input of the fourth flipflop, said clock signal being sent to both said basic element and the fourth flipflop; the gates of an eighth and a ninth transistor (T31, T32) being connected to the second input of the NAND gate (ND4) to receive said control signal (RS) of the asynchronous reset function; the second input of a second NAND gate (ND3) being connected to the gates of said sixth and seventh transitors (T41, T42) to receive said control signal (ST) of the asynchronous set function.

**Revendications**

1. Elément de base de logique séquentielle en technologie CMOS utilisant des transistors du type à enrichissement, qui effectue des fonctions binaires de base de transfert et/ou stockage en mémoire des données et qui fonctionne avec un signal unique de synchronisme (CK) dont le niveau actif commande la fonction de transfert des données et dont le niveau inactif commande la fonction de stockage des données, qui a des terminaux d'alimentation du courant (V$_{SS}$,V$_{DD}$) à être connectés à des tensions d'alimentation qui correspondent aux niveaux binaires bas et haut, respectivement, et est essentiellement constitué par:

- un inverseur logique (INV2) dont la sortie (DU2) est celle de l'élément de base;
- un premier transistor (T21) du type PMOS qui transfère une donnée appliquée à son entrée, qui est aussi l'entrée (DI2) de l'élément de base, à l'entrée (B) dudit inverseur logique lorsque ledit signal de synchronisme (CK), appliqué à sa grille, a un niveau actif, au cas contraire il découple l'entrée de l'élément de base de celle de l'inverseur;
- un premier réseau de réaction positive entre sortie et entrée dudit inverseur logique, qui contient un deuxième transistor (T24) du type NMOS connecté entre le terminal d'alimentation pour la tension qui correspond au niveau binaire bas et l'entrée (B) de l'inverseur, la grille étant connectée à la sortie de l'inverseur (DU2), et commutant à la tension d'alimentation respective l'entrée de l'inverseur au cas de tension près du niveau logique haut transféré à sa grille de la sortie de l'inverseur;
- un second réseau de réaction positive (T23,T25) entre sortie et entrée dudit inverseur logique, qui contient un troisième transistor (T23) du type PMOS couplé entre le terminal d'alimentation pour la tension qui correspond au niveau binaire haut auquel sa source est connectée et l'entrée (B) de l'inverseur, le courant à travers le troisième transistor (T23) étant commandé par au moins un autre transistor (T22,T25) par ledit signal de synchronisme (CK) qui, lorsqu'il est inactif, permet à l'entrée de l'inverseur d'être commutée à la tension d'alimentation respective à travers ledit troisième transistor sous la commande de la tension à la sortie de l'inverseur (DU2) transférée à sa grille, l'autre transistor, c'est-à-dire le quatrième transistor (T22) ayant sa source connectée au terminal d'alimentation (V$_{DD}$) pour la tension qui correspond au niveau binaire haut, et la grille audit signal de synchronisme (CK), caractérisé en ce que pour avoir une phase active au niveau de tension bas du signal de synchronisme (CK),

- ledit second réseau de réaction positive comprend, outre le quatrième transistor (T22) qui est du type PMOS, un cinquième transistor (T25) du type NMOS ayant la source connectée à la sortie de l'inverseur (INV2), et la grille connectée au signal de synchronisme (CK); et
- ledit troisième transistor (T23) a le drain connecté à l'entrée de l'inverseur logique (INV2); la grille du troisième, le drain du quatrième et le drain du cinquième transistor étant interconnectés.

2. Elément de base selon la revendication 1, caractérisé en ce que, pour effectuer les fonctions supplémentaires de remise à zéro et mise à 1 asynchrones, il comprend en outre:

- ledit inverseur logique (INV2) est réalisé avec une porte NAND (ND4); une entrée et la sortie de ladite porte NAND remplaçant l'entrée et la sortie de l'inverseur logique; un signal de commande (ST4) de ladite fonction de mise à 1 asynchrone étant envoyé à une seconde entrée de ladite porte NAND, ledit signal de commande étant du type actif bas;
- un sixième transistor (T42) du type NMOS, dont le canal est mis en série avec celui dudit deuxième transistor (T24);
- un septième transistor (T41) du type PMOS, dont le canal est mis en parallèle avec celui dudit troisième transistor (T23); ledit sixième et septième transistors recevant à la grille un signal de commande (RS4) de ladite fonction de remise à zéro asynchrone du type actif bas.

3. Réseau logique séquentiel en technologie CMOS utilisant l'élément de base selon la revendication 1, caractérisé en ce qu'il réalise une bascule maître-esclave du type D et qu'il comprend une première bascule (LAN), ayant une phase active au niveau haut de la tension du signal de synchronisme (CK) en position maître, suivie d'une deuxième baseule, c'est-à-dire l'élément de base (LAP) ayant une phase active au niveau bas de la tension du signal de synchronisme en position esclave; l'entrée de la première bascule étant l'entrée des données du réseau, la sortie dudit circuit de base étant la sortie des données du réseau; la sortie de la première bascule étant connectée à l'entrée dudit élément de base, ledit signal de synchronisme étant envoyé soit à la première bascule, soit audit élément de base.

4. Réseau logique séquentiel en technologie CMOS utilisant l'élément de base selon la revendication 1, caractérisé en ce qu'il réalise une bascule du type maître-esclave de type D, et comprend lesdits éléments de base (LAP) ayant une phase active au niveau bas de la tension du signal de synchronisme (CK) en position maître, suivis d'une deuxième bascule (LAN) ayant une phase active au niveau haut de la tension du signal de synchronisme en position esclave; l'entrée dudit élément de base étant l'entrée des données du réseau, la sortie de ladite deuxième bascule étant la sortie des données du réseau; la sortie dudit élément de base étant connectée à l'entrée de la deuxième bascule, ledit signal de synchronisme étant envoyé soit aux éléments de base, soit à la deuxième bascule.

5. Réseau logique séquentiel en technologie CMOS utilisant l'élément de base de la revendication 2, caractérisé en ce que qu'il réalise une bascule maître-esclave du type D ayant des fonctions supplémentaires de mise à 1 et de remise à zéro asynchrones et comprend une troisième bascule (LSTN) ayant une phase active au niveau haut de la tension du signal de synchronisme (CK) en position maître, suivie dudit élément de base (LSTP) ayant une phase active au niveau bas de la tension du signal de synchronisme en position esclave; l'entrée de la troisième bascule étant l'entrée des données du réseau, la sortie dudit élément de base étant la sortie des données du réseau; la sortie de la troisième bascule étant connectée à l'entrée dudit élément de base, ledit signal de synchronisme étant envoyé soit à la troisième bascule, soit audit élément de base; les grilles d'un huitième et d'un neuvième transistors (T31,T32) étant connectées à la seconde entrée de ladite première porte NAND (ND4) pour recevoir ledit signal de commande (ST) de la fonction de mise à 1 asynchrone; la seconde entrée d'une deuxième porte NAND (ND3) étant connectée aux grilles desdits sixième et septième transistors (T41,T42) pour recevoir ledit signal de commande (RS) de la fonction de remise à zéro asynchrone.

6. Réseau logique séquentiel en technologie CMOS utilisant l'élément de base de la revendication 2, caractérisé en ce qu'il réalise une bascule maître-esclave du type D avec des fonctions supplémentaires de mise à 1 et remise à zéro asynchrones et qu'il comprend ledit élément de base (LSTP) ayant une phase active au niveau bas de la tension du signal de synchronisme (CK) en position maître, suivi d'une quatrième bascule (LSTN) ayant une phase active au niveau haut de la tension du signal de synchronisme en position esclave; l'entrée dudit élément de base étant l'entrée des données du réseau, la sortie de la quatrième bascule étant la sortie des données du réseau, la sortie dudit élément de base étant connectée à l'entrée de de la quatrième bascule, ledit signal de synchronsme étant envoyé soit audit élément de base, soit à la quatrième bascule; les grilles d'un huitième et d'un neuvième transistors (T31,T32) étant connectées à la seconde entrée de la porte NAND (ND4) pour recevoir ledit signal de commande (RS) de la fonction de remise à zéro asynchrone; la seconde entrée d'une deuxième porte NAND (ND3) étant connectée aux grilles dudit sixième et septième transistors (T41,T42) pour recevoir ledit signal de commande (ST) de la fonction de mise à 1 asynchrone.

**Patentansprüche**

1. Grundelement der sequenziellen Logik in CMOS-Technologie unter Verwendung von Transistoren des Anreicherungs-Typs, das binäre Grundfunktionen des Datentransfers und/oder der Datenspeicherung ausübt und mit Hilfe eines einzigen Taktsignals (CK) arbeitet, dessen aktiver Pegel die Datentransferfunktion steuert und dessen nicht-aktiver Pegel die Datenspeicherfunktion steuert, das ferner Stromversorgungsanschlüsse ($V_{SS}$, $V_{DD}$) zum Anschluß an Versorgungsspannungen, die dem niedrigen bzw. hohen binären Pegel entsprechen, aufweist und das aus folgenden Hauptbestandteilen besteht:

- einem logischen Inverter (INV2), dessen Ausgang (DU2) der Ausgang des Grundelements ist;

- einem ersten Transistor (T21) vom PMOS-Typ, der ein an seinen Eingang, welcher zugleich der Eingang (DI2) des Grundelements ist, angelegtes Datum zum Eingang (B) des logischen Inverters durchläßt, wenn das an seinem Steuereingang angelegte Taktsignal (CK) seinen aktiven Pegel aufweist, und andernfalls den Eingang des Grundelements von dem des Inverters trennt;

- einer ersten positiven Rückkopplungsschaltung zwischen dem Ausgang und dem Eingang des logischen Inverters, die einen zweiten Transistor (T24) vom NMOS-Typ enthält, der zwischen den Versorgungsanschluß für die dem niedrigen binären Pegel entsprechende Spannung und dem Eingang (B) des Inverters geschaltet ist und dessen Steuereingang mit dem Inverter-Ausgang (DU2) verbunden sind, und der die betreffende Versorgungsspannung zum Invertereingang dann durchschaltet, wenn eine Spannung nahe dem hohen logischen Pegel vom Inverter-Ausgang zu seinem Steuereingang übertragen wird;
- einer zweiten positiven Rückkopplungsschaltung (T23,T25) zwischen dem Ausgang und dem Eingang des logischen Inverters, die einen dritten Transistor (T23) vom PMOS-Typ enthält, der zwischen den Versorgungsanschluß für die dem hohen binären Pegel entsprechende Spannung, an den seine Quelle angeschlossen ist, und den Inverter-Eingang (B) geschaltet ist, wobei der Strom durch den dritten Transistor (T23) über wenigstens einen weiteren Transistor (T22,T25) durch das Taktsignal (CK) gesteuert ist, das, wenn es nicht-aktiv ist, im dritten Transistor das Durchschalten der betreffenden Versorgungsspannung zum Inverter-Eingang unter Steuerung durch die Spannung am Inverter-Ausgang (DU2), die zu seinem Steuereingang übertragen wird, erlaubt, wobei der weitere, also vierte Transistor (T22) mit seiner Quelle an den Versorgungsanschluß (V$_{DD}$) für die dem hohen Binärpegel entsprechende Spannung und mit seinem steuereingang an das Taktsignal (CK) angeschlossen ist,

dadurch gekennzeichnet, daß zum Erzielen einer aktiven Phase am niedrigen Spannungspegel des Taktsignals (CK)
- die zweite positive Rückkopplungsschaltung außer dem vierten Transistor (T22), der vom PMOS-Typ ist, einen fünften Transistor (T25) vom NMOS-Typ aufweist, dessen Quelle mit dem Ausgang des Inverters (INV2) und dessen Steuereingang mit dem Taktsignal (CK) verbunden ist; und
- der dritte Transistor (T23) mit seinem Abfluß mit dem Eingang des logischen Inverters (INV2) verbunden ist und der Steuereingang des dritten, der Abfluß des vierten und der Abfluß des fünften Transistors miteinander verbunden sind.

2. Grundelement nach Anspruch 1, dadurch gekennzeichnet, daß es zur Durchführung von ergänzenden Funktionen des asynchronen Stellens und Rückstellens weiterhin umfaßt:
- der logische Inverter (INV2) ist mit einem NAND-Glied (ND4) realisiert, von dem ein Eingang und der Ausgang an die Stelle des Eingangs und Ausgangs des logischen Inverters treten, wobei an einen zweiten Eingang des NAND-Glieds ein Steuersignal (ST4) der asynchronen Stellfunktion, dessen aktiver Pegel der niedrige Pegel ist, angelegt ist:
  - einen sechsten Transistor (T42), und zwar einen NMOS-Transistor, dessen Kanal in Reihe mit dem des zweiten Transistors (T24) geschaltet ist;
  - einen siebten Transistor (T41), und zwar einen PMOS-Transistor, dessen Kanal dem des dritten Transistors (T23) parallelgeschaltet ist; wobei der sechste und der siebte Transistor am Gatter ein Steuersignal (RS4) der asynchronen Rückstellfunktion, dessen aktiver Pegel der niedrige Pegel ist, empfängt.

3. Sequentielle Logikschaltung in CMOS-Technologie unter Verwendung des Grundelements nach Anspruch 1, dadurch gekennzeichnet, daß sie einen Master-Slave-Flip-Flop des D-Typs bildet und in der beherrschenden Stellung einen ersten Flip-Flop (LAN) mit der aktiven Phase beim hohen Spannungspegel des Taktsignals (CK) umfaßt, dem in der beherrschten Stellung ein zweiter Flip-Flop, nämlich das Grundelement (LAP), das die aktive Phase beim niedrigen Spannungspegel des Taktsignals hat, folgt; wobei der Eingang des ersten Flip-Flops der Dateneingang der Logikschaltung und der Datenausgang des Grundelements der Datenausgang der Logikschaltung ist, der Ausgang des ersten Flip-Flops mit dem Eingang des Grundelements verbunden ist und das Taktsignal sowohl an den ersten Flip-Flop als auch an das Grundelement geliefert ist.

4. Sequentielle Logikschaltung in CMOS-Technologie unter Verwendung des Grundelements nach Anspruch 1, dadurch gekennzeichnet, daß sie einen Master-Slave-Flip-Flop des D-Typs bildet und in der beherrschenden Stellung das Grundelement (LAP) mit der aktiven Phase beim niedrigen Spannungspegel des Taktsignals (CK) umfaßt, dem in der beherrschten Stellung ein zweiter Flip-Flop (LAN), der die aktive Phase beim hohen Spannungspegel des Taktsignals hat, folgt; wobei der Eingang des Grundelements der Dateneingang der Logikschaltung und der Ausgang des zweiten Flip-Flops der Datenausgang der Logikschaltung ist, der Ausgang des Grundelements mit dem Eingang des zweiten Flip-Flops verbunden ist und das Taktsignal sowohl an das Grundelement als auch an den zweiten Flip-Flop geliefert ist.

5. Sequentielle Logikschaltung in CMOS-Technologie unter Verwendung des Grundelements nach Anspruch 2, dadurch gekennzeichnet, daß sie einen Master-Slave-Flip-Flop des D-Typs mit zusätzlichen asynchronen Stell- und Rückstellfunktionen bildet und in der beherrschenden Stellung einen dritten Flip-Flop (LSTN) umfaßt, der seine aktive Phase beim hohen Spannungspegel des Taktsignals (CK) hat und dem in der beherrschten Stellung das Grundelement (LSTP), das seine aktive Phase beim niedrigen Spannungspegel des Taktsignals hat, folgt; daß der Eingang des dritten Flip-Flops der Dateneingang der Logikschaltung und der Ausgang des Grundelements der Datenausgang der Logikschaltung ist, der Ausgang des dritten Flip-Flops mit dem Eingang des Grundelements verbunden ist, das Taktsignal sowohl an den dritten Flip-Flop als auch an das Grundelement geliefert ist, die Steuereingänge eines achten und eines neunten Transistors (T31,T32) mit dem zweiten Eingang des ersten NAND-Glieds (ND4) verbunden sind, um das Steuersignal (ST) der asynchronen Stellfunktion zu empfangen, und der zweite Eingang des zweiten NAND-Glieds (ND3) mit den Steuereingängen des sechsten und des siebten Transistors (T41,T42) verbunden ist, um das Steuersignal (RS) der asynchronen Rückstellfunktion zu empfangen.

6. Sequentielle Logikschaltung in CMOS-Technologie unter Verwendung des Grundelements nach Anspruch 2, dadurch gekennzeichnet, daß sie einen Master-Slave-Flip-Flop des D-Typs mit zusätzlichen asynchronen Stell- und Rückstellfunktionen bildet und in der beherrschenden Stellung das Grundelement (LSTP) umfaßt, das seine aktive Phase beim niedrigen Spannungspegel des Taktsignals (CK) hat und dem in der beherrschten Stellung ein vierter Flip-Flop (LSTN), der seine aktive Phase beim hohen Spannungspegel des Taktsignals hat, folgt; daß der Eingang des Grundelements der Dateneingang der Logikschaltung und der Ausgang des vierten Flip-Flops der Datenausgang der Logikschaltung ist, der Ausgang des Grundelements mit dem Eingang des vierten Flip-Flops verbunden ist, das Taktsignal sowohl an das Grundelement als auch an den vierten Flip-Flop geliefert ist, die Steuereingänge eines achten und eines neunten Transistors (T31,T32) mit dem zweiten Eingang des NAND-Glieds (ND4) verbunden sind, um das Steuersignal (RS) der asynchronen Rückstellfunktion zu empfangen, und der zweite Eingang eines zweiten NAND-Glieds (ND3) mit den Steuereingängen des sechsten und des siebten Transistors (T41,T42) verbunden ist, um das Steuersignal (ST) der asynchronen Stellfunktion zu empfangen.

FIG. 1

FIG. 2

FIG.3

FIG.4

FIG. 5

FIG. 6